# EUROPEAN PATENT APPLICATION

(11) **EP 3 425 654 A1**
(43) Date of publication of application: **09.01.2019**
(21) Application number: 18155641.6
(22) Date of filing: 07.02.2018
(51) Int. Cl.: H01H 47/00, H01H 9/54

(54) **RELAY DEVICE**

(30) Priority: 03.07.2017 JP 2017130190
(71) Applicant: OMRON CORPORATION, Kyoto-shi, Kyoto 600-8530 (JP)
(72) Inventor: HIGUCHI, Toshiyuki, Kyoto-shi, Kyoto 600-8530 (JP); KAMISONO, Daichi, Kyoto-shi, Kyoto 600-8530 (JP); FUKUMOTO, Tetsuya, Kyoto-shi, Kyoto 600-8530 (JP)
(74) Representative: Emde, Eric

(57) **Abstract**

A miniature and inexpensive relay device is provided. A relay device, i.e., a relay unit (1), includes a breakdown detection unit (41) that does not detect breakdown of an operation of a first switching element (20) and detect breakdown of an operation of a second switching element (30). When a switching control unit (42) switches an external load circuit from non-conductivity to conductivity, the switching control unit (42) switches the second switching element from non-conductivity to conductivity after switching the first switching element from non-conductivity to conductivity. When the switching control unit switches the load circuit from conductivity to non-conductivity, the switching control unit switches the first switching element from conductivity to non-conductivity after switching the second switching element from conductivity to non-conductivity.

## Description

### BACKGROUND

### Technical Field

The present invention relates to a relay device connected to an external load circuit and switching between conductivity and non-conductivity of the load circuit.

### Description of Related Art

When welding or fixing of relay contacts occurs in relay devices that receive electric signals from the outside and switch electric circuits ON and OFF, there is a problem that opening of switching elements may not be executed. Accordingly, for example, Patent Document 1 discloses a safety switching device in which safety connection releasing of a power source is ensured by using at least two switching elements in series even when one switching element is fixed. Patent Document 1 discloses a switching device that has a forced guide type relay capable of checking safety connection releasing of power supply from the position of an auxiliary contact by mechanically interlocking a switching position of the auxiliary contact with a switching position of an operation contact.

### Patent Documents

[Patent Document 1] Japanese Publication No. 2003-514361 of the PCT International Publication (disclosed on 15 April 2003)
[Patent Document 2] Japanese Patent Application Laid-open No. 2003-162948 (disclosed on 6 June 2003)

### SUMMARY

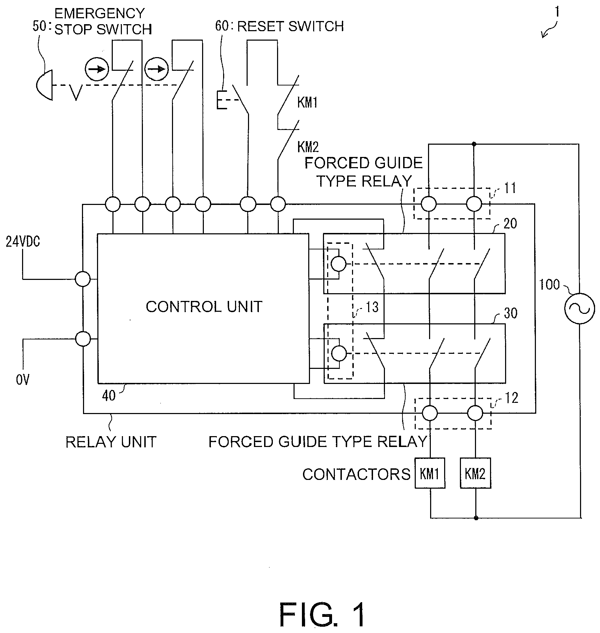

It is necessary for the safety switching device disclosed in Patent Document 1 to use the forced guide type relay as a switching element, but the forced guide type relay has a special mechanism and thus is complicated and expensive. FIG. 1 illustrates an example of a configuration of a relay device using a forced guide type relay as a switching element. In the illustrated example, since the forced guide type relay has a structure in which a normally open contact serving as a main contact and a normally closed contact serving as an auxiliary contact are mechanically interlocked with each other, the size of the forced guide type relay is greater than a structure in which a general purpose relay with no forced guide mechanism as a switching element is used. In order to prevent an erroneous operation due to welding or the like of the main contact, at least two forced guide type relays are required. Therefore, there are problems that the size of the device increases and cost also increases.

An object of the invention is to provide a miniature and inexpensive relay device capable of reliably switching between conductivity and non-conductivity of a load circuit.

In order to resolve the foregoing problems, according to an embodiment of the invention, there is provided a relay device that is connected to an external load circuit via a first output terminal and a second output terminal and switches between conductivity and non-conductivity of the load circuit. The relay device includes: a first switching element and a second switching element connected to each other in series between the first output terminal and the second output terminal; a breakdown detection unit configured to detect breakdown of operations of the switching elements; and a switching control unit configured to control switching of the first switching element and the second switching element. The breakdown detection unit does not detect the breakdown of the operation of the first switching element and detects the breakdown of the operation of the second switching element. When the switching control unit switches the load circuit from non-conductivity to conductivity, the switching control unit switches the second switching element from non-conductivity to conductivity after switching the first switching element from non-conductivity to conductivity, and when the switching control unit switches the load circuit from conductivity to non-conductivity, the switching control unit switches the first switching element from conductivity to non-conductivity after switching the second switching element from conductivity to non-conductivity.

In the relay device according to the embodiment of the present invention, the second switching element may include a normally open contact and a normally closed contact mechanically interlocked with the normally open contact. The breakdown detection unit may detect occurrence of the breakdown of the operation in accordance with a control state of the switching control unit and a conductive state of the normally closed contact included in the second switching element.

In the relay device according to the embodiment of the present invention, the first switching element may be formed by the normally open contact.

In the relay device according to the embodiment of the present invention, switching rated capacity of the first switching element may be greater than switching rated capacity of the second switching element.

In the relay device according to the embodiment of the present invention, the first switching element may be a semiconductor element.

According to the embodiment of the present invention, it is possible to obtain the advantage of providing the miniature and inexpensive relay device capable of reliably switching between conductivity and non-conductivity of a load circuit.

### BRIEF DESCRIPTION OF THE DRAWINGS

FIG. 1 is a block diagram illustrating an example of a configuration of main units of a relay unit in which two forced guide type relays are arranged in series.
FIG. 2 is a block diagram illustrating an example of a configuration of main units of a relay unit according to a first embodiment of the present invention.
FIG. 3 is a timing chart illustrating an example of a switching timing of each element in the relay unit in FIG. 2.
FIG. 4 is a block diagram illustrating an example of a configuration of main units of a relay unit according to a modification example of the present invention.

### DESCRIPTION OF THE EMBODIMENTS

### [First embodiment]

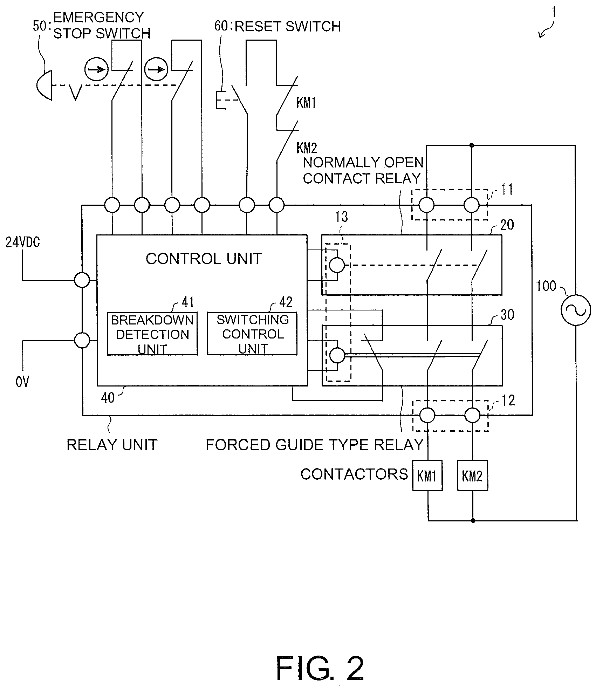

Hereinafter, a first embodiment of the present invention will be described in detail with reference to FIG. 2.

### (Configuration of relay unit)

A relay unit 1 according to the embodiment is a relay device that is connected to a load circuit including an external alternating-current power source 100 and an electric load (for example, a motor) (not illustrated) and switches between conductivity and non-conductivity of the load circuit. In the illustrated example, the relay unit 1 includes a first switching element 20, a second switching element 30, a control unit 40, an emergency stop switch 50, and a reset switch 60. The control unit 40 includes a breakdown detection unit 41 and a switching control unit 42.

The relay unit 1 is electrically connected to a load circuit through a first output terminal 11 and a second output terminal 12. The relay unit 1 also switches the load circuit to non-conductivity to stop an operation of the load circuit when the emergency stop switch 50 is pressed. The relay unit 1 switches the load circuit to conductivity to start (resume) the operation of the load circuit when the reset switch 60 is pressed.

The first output terminal 11 is a terminal installed in the relay unit 1 and is connected to the load circuit in the configuration illustrated in FIG. 2.

The second output terminal 12 is a terminal installed in the relay unit 1 and is connected to the load circuit via contactors KM1 and KM2 in the configuration in FIG. 2.

The first output terminal 11 and the second output terminal 12 can input a current from the alternating-current power source 100 to the load circuit when the switches of the first switching element 20 and the second switching element 30 are both ON.

A switching control terminal 13 is a terminal installed in the relay unit 1 and is used to connect the control unit 40 to the first switching element 20 and the second switching element 30. The switching control terminal 13 transmits a switching signal to be operated at switching positions of the first switching element 20 and the second switching element 30 to the first switching element 20 and the second switching element 30.

The first switching element 20 is a relay capable of switching ON and OFF by receiving the switching signal from the control unit 40 via the switching control terminal 13. In other words, the first switching element 20 switches an internal switch ON and OFF under the control of the control unit 40. The first switching element 20 is arranged in series with the second switching element 30 between the first output terminal 11 and the second output terminal 12 of the relay unit 1. Switching rated capacity of the first switching element 20 is set to be greater than switching rated capacity of the second switching element 30.

In the embodiment, the first switching element 20 is a normally open contact relay formed by a normally open contact. The normally open contact relay is a relay in which a relay contact is turned off in a state in which no voltage is applied. When the relay contact breaks down due to welding or the like, the normally open contact relay may not detect a breakdown, but has a simpler and less expensive configuration than a forced guide type relay unlike the forced guide type relay.

Like the first switching element 20, the second switching element 30 is a relay capable of switching ON and OFF by receiving the switching signal from the control unit 40 via the switching control terminal 13. In other words, the second switching element 30 switches an internal switch ON and OFF under the control of the control unit 40. In the embodiment, the second switching element 30 is configured as a forced guide type relay. Here, the forced guide type relay is a relay in which a normally open contact and a normally closed contact are mechanically connected to each other by a guide. When the normally open contact is welded (fixed) in the forced guide type relay, the normally closed contact interlocked by the guide becomes an opened circuit. That is, the control unit 40 can detect whether the normally open contact is fixed by confirming a state of the normally closed contact.

In FIG. 2, two normally open contacts of the first switching element 20 and two normally open contacts of the second switching element 30 are illustrated, but the present invention is not particularly limited to this. One or three or more normally open contacts may be used. For the relay unit illustrated in FIG. 2, redundancy is achieved by arranging two relays of the first switching element 20 and the second switching element 30 in series.

The control unit 40 performs overall control of each unit of the relay unit 1 and includes the breakdown detection unit 41 and the switching control unit 42.

The switching control unit 42 controls switching of the first switching element 20 and the second switching element 30. More specifically, the switching control unit 42 generates a switching signal for the first switching element 20 and the second switching element 30. When the switching control unit 42 switches the load circuit from non-conductivity to conductivity, the switching control unit 42 switches the second switching element 30 from non-conductivity to conductivity after switching the first switching element 20 from non-conductivity to conductivity. When the switching control unit 42 further switches the load circuit from conductivity to non-conductivity, the switching control unit 42 switches the first switching element 20 from conductivity to non-conductivity after switching the second switching element 30 from conductivity to non-conductivity. As long as a switching order of the first switching element 20 and the second switching element 30 can be controlled, any configuration of the switching control unit 42 may be used. For example, any delay circuit may be contained and a generation timing of the switching signal may be delayed using the delay circuit.

The breakdown detection unit 41 acquires information regarding the switching element and detects occurrence of breakdown of an operation of the switching element based on the acquired information. In the embodiment, the breakdown detection unit 41 detects occurrence of breakdown of an operation in accordance with a control state of the switching control unit 42 and in a conductive state of the normally closed contact mechanically interlocked with the normally open contact in the second switching element 30. For example, when the switching control unit 42 transmits the switching signal for setting the second switching element 30 to non-conductivity and the normally closed contact installed in the switching element 30 is non-conductive, the breakdown detection unit 41 detects occurrence of breakdown of an operation such as fixing in the normally open contact of the second switching element 30. Any of various known schemes may be applied to a detection method.

The breakdown detection unit 41 may execute control such that the normally open contact of the first switching element 20 is opened when occurrence of breakdown of an operation is further detected. This control may be realized by a circuit configuration or may be realized by a logic circuit. By executing such control, it is possible to switch the load circuit to non-conductivity by the first switching element 20 even when breakdown of an operation such as contact welding occurs in the second switching element 30.

In this way, in the embodiment, occurrence of breakdown due to welding or the like of the relay contact in the second switching element 30 is detected by the breakdown detection unit 41 and the normally closed contact installed in the second switching element 30. The detection of breakdown due to welding or the like of the relay contact in the second switching element 30 is not limited to the foregoing configuration and can be realized with any known breakdown detection configuration.

The emergency stop switch 50 is a switch that switches the load circuit from a conductive state to a non-conductive state. The emergency stop switch 50 can switch between a release state and a stop state. Here, the stop state is a state in which the load circuit enters a non-conductive state and the release state is a state in which the load circuit enters a conductive state.

In the illustrated example, the control unit 40 generates a stop signal when the emergency stop switch 50 is pressed. In accordance with the generated stop signal, the control unit 40 switches the first switching element 20 and the second switching element 30 OFF and switches the load circuit from conductivity to non-conductivity.

The reset switch 60 is a switch that stalls (resumes) an operation of the relay unit 1. When the reset switch 60 is pressed in the illustrated example, the contactors KM1 and KM2 connected to the reset switch 60 are interlocked and the contactors KM1 and KM2 installed on the side of the second output terminal 12 operate. An input of a current to the load circuit can be reset in accordance with switching of the contactors KM1 and KM2 installed on the side of the second output terminal 12.

That is, a user presses the emergency stop switch 50 to stop the load circuit when the user desires to switch the load circuit to non-conductivity in an emergency state or the like. After the emergency stop is executed and safety is confirmed, the emergency stop switch 50 is first returned to the release state. Thereafter, by pressing the reset switch 60 to reset the load circuit, the load circuit transitions to the conductive state.

### (Operation of relay unit)

An operation of the relay unit 1 according to the embodiment will be described below.

When the switching control unit 42 of the relay unit 1 switches the load circuit from non-conductivity to conductivity, the relay unit 1 switches the second switching element 30 from non-conductivity to conductivity after switching the first switching element 20 from non-conductivity to conductivity. When the switching control unit 42 switches the load circuit from conductivity to non-conductivity, the switching control unit 42 switches the first switching element 20 from conductivity to non-conductivity after switching the second switching element 30 from conductivity to non-conductivity.

Here, consider a case in which a large current flows at one time when the load circuit is switched from the non-conductive state to the conductive state. At this time, prior to the second switching element 30, the switch of the first switching element 20 is switched from OFF to ON by the switching control unit 42. Since the second switching element 30 is switched ON later than the first switching element 20, a current path connecting the relay unit 1 to the load circuit is formed at a timing at which the second switching element 30 is turned on. Accordingly, when arc occurs between the relay contacts due to the large current, arc occurs between the relay contacts of the second switching element 30. That is, in the relay unit 1 according to the embodiment, breakdown due to welding or the like of the relay contacts is expected to occur in the second switching element 30. In this case, when the breakdown detection unit 41 detects breakdown of the second switching element 30, the control unit 40 can switch the switch of the first switching element 20 OFF.

The first switching element 20 is suitable for a configuration with switching rated capacity higher than the second switching element 30 so that the first switching element 20 is not simultaneously broken down along with the second switching element 30.

### (Switching timing of switching element)

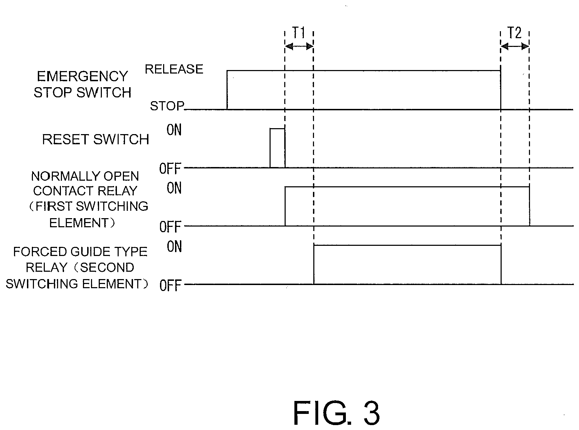

A switching timing of each switching element in the relay unit 1 according to the embodiment will be described with reference to FIG. 3. FIG. 3 is a timing chart illustrating an example of a switching timing of each element in the relay unit 1 in FIG. 2.

In the illustrated example, the switching starts from a state in which the emergency stop switch 50 enters the stop state. Thereafter, safety is confirmed and the emergency stop switch 50 transitions to the release state. At this time, both the first switching element 20 which is the normally open contact relay and the second switching element 30 which is the forced guide type relay are in an OFF state. That is, the first switching element 20 and the second switching element 30 enter a state in which no current flows in the load circuit.

Next, consider a case in which the reset switch 60 is pressed at a certain time point and the state of the reset switch 60 is switched from OFF to ON. At this time, the first switching element 20 which is the normally open contact is switched ON prior to the second switching element 30 which is the forced guide type relay under the control of the switching control unit 42. In the illustrated example, the first switching element 20 is switched ON prior to the second switching element 30 by time T1.

Thereafter, consider a case in which the user presses the emergency stop switch 50 at a timing at which emergency stop is required and the emergency stop switch 50 is switched from the release state to the stop state. At this time, the first switching element 20 which is the normally open contact relay is switched OFF later than the second switching element 30 which is the forced guide type relay under the control of the switching control unit 42. In the illustrated example, the first switching element 20 is switched OFF later than the second switching element 30 by time T2.

In this way, the relay unit 1 according to the embodiment monitors breakdown of the second switching element 30 using the control unit 40 and can raise a possibility of, for example, arc or the like at the time of flowing a large current to the relay unit 1 occurring in the second switching element 30. Thus, it is possible to configure localized range of breakdown prediction and monitor the localized range. Further, since the first switching element 20 is the normally open contact relay, it is possible to obtain the advantage of providing the less expensive relay unit 1. Accordingly, it is possible to obtain the advantage of providing the miniature and inexpensive relay unit 1.

The relay unit 1 according to the embodiment is suitable to be applied to, for example, a safety control circuit device such as an emergency stop device or a door interlocking device.

### [Modification examples]

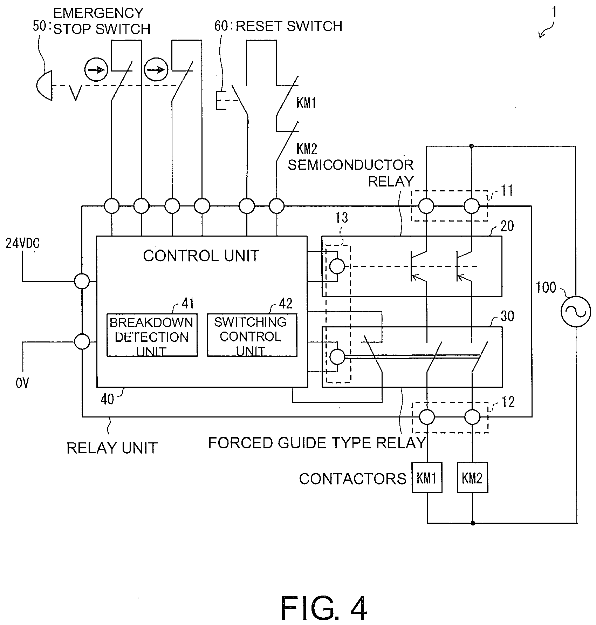

In the foregoing embodiments, the first switching element 20 includes the mechanical relay that mechanically switches ON and OFF at both relay contacts. However, the first switching element 20 may be a relay capable of switching ON and OFF via the switching control terminal 13 from the control unit 40 or may be a semiconductor relay including, for example, a semiconductor element. A configuration in which the first switching element 20 which is a semiconductor relay is included is illustrated in FIG. 4. In the illustrated example, the switching control unit 42 switches between conductivity and non-conductivity between an emitter and a collector by controlling a base current of a transistor via the switching control terminal 13. Since there is no relay contact in the semiconductor relay, it is possible to suppress breakdown such as welding of the relay contact by arc or the like.

### [Conclusion]

According to Embodiment 1 of the present invention, a relay device (the relay unit 1) is a relay device connected to an external load circuits via a first output terminal (11) and a second output terminal (12) and switches between conductivity and non-conductivity of the load circuit. The relay device includes: a first switching element (20) and a second switching element (30) connected to each other in series between the first output terminal and the second output terminal; a breakdown detection unit (41) configured to detect breakdown of operations of the switching elements; and a switching control unit (42) configured to control switching of the first switching element and the second switching element. The breakdown detection unit does not detect the breakdown of the operation of the first switching element and detects the breakdown of the operation of the second switching element. When the switching control unit switches the load circuit from non-conductivity to conductivity, the switching control unit switches the second switching element from non-conductivity to conductivity after switching the first switching element from non-conductivity to conductivity, and when the switching control unit switches the load circuit from conductivity to non-conductivity, the switching control unit switches the first switching element from conductivity to non-conductivity after switching the second switching element from conductivity to non-conductivity.

In this configuration, the breakdown detection unit of the relay device detects breakdown of the second switching element. For example, when a large current flows to the relay device, breakdown easily occurs in the second switching element. Thus, by localizing a breakdown range and monitoring the localized range, it is possible to obtain the advantage of providing the miniature and inexpensive relay device.

According to Embodiment 2 of the present invention, in the relay device (the relay unit 1) according to Embodiment 1 of the present invention, the second switching element (30) may include a normally open contact and a normally closed contact mechanically interlocked with the normally open contact. The breakdown detection unit (41) may detect occurrence of the breakdown of the operation in accordance with a control state of the switching control unit (42) and a conductive state of the normally closed contact included in the second switching element (30).

In this configuration, the relay device can determine whether breakdown of an operation of the second switching element occurs in accordance with a control state of the switching control unit and a conductive state of the normally closed contact.

According to Embodiment 3 of the present invention, in the relay device (the relay unit 1) according to Embodiment 1 or 2 of the present invention, the first switching element (20) may be formed by the normally open contact.

In this configuration, since the relay device includes the first switching element configured as the normally open contact relay, it is possible to miniaturize the relay device less expensively than a relay device in which a relay including a forced guide mechanism is redundant.

According to Embodiment 4 of the present invention, in the relay device (the relay unit 1) according to any one of Embodiments 1 to 3 of the present invention, switching rated capacity of the first switching element (20) may be greater than switching rated capacity of the second switching element (30).

In this configuration, it is possible to suppress a possibility of the first switching element being simultaneously broken down along with the second switching element.

According to Embodiment 5 of the present invention, in the relay device (the relay unit 1) according to Embodiments 1 to 4 of the present invention, the first switching element (20) may be a semiconductor element.

In this configuration, by configuring the first switching element as a semiconductor element, it is possible to provide the relay device in which switching is executed contactlessly and breakdown due to welding of a contact is suppressed.

### [Reference Signs List]

1 Relay unit (relay device)
11 First output terminal
12 Second output terminal
13 Switching control terminal
20 First switching element
30 Second switching element
40 Control unit
41 Breakdown detection unit
42 Switching control unit
50 Emergency stop switch
60 Reset switch
100 Alternating-current power source
KM1, KM2 contactors
T1, T2 time

## Claims

1. A relay device (1) that is connected to an external load circuit via a first output terminal (11) and a second output terminal (12) and switches between conductivity and non-conductivity of the load circuit, the relay device (1) comprising:
a first switching element (20) and a second switching element (30) connected to each other in series between the first output terminal (11) and the second output terminal (12);
a breakdown detection unit (41) configured to detect breakdown of operations of the switching elements; and
a switching control unit (42) configured to control switching of the first switching element (20) and the second switching element (30),
wherein the breakdown detection unit (41) does not detect the breakdown of the operation of the first switching element (20) and detects the breakdown of the operation of the second switching element (30), and
wherein, when the switching control unit (42) switches the load circuit from non-conductivity to conductivity, the switching control unit (42) switches the second switching element (30) from non-conductivity to conductivity after switching the first switching element (20) from non-conductivity to conductivity, and when the switching control unit (42) switches the load circuit from conductivity to non-conductivity, the switching control unit (42) switches the first switching element (20) from conductivity to non-conductivity after switching the second switching element (30) from conductivity to non-conductivity.

2. The relay device (1) according to claim 1,
wherein the second switching element (30) includes a normally open contact and a normally closed contact mechanically interlocked with the normally open contact, and
wherein the breakdown detection unit (41) detects occurrence of the breakdown of the operation in accordance with a control state of the switching control unit (42) and a conductive state of the normally closed contact included in the second switching element (30).

3. The relay device (1) according to claim 1 or 2,
wherein the first switching element (20) is formed by the normally open contact.

4. The relay device (1) according to any one of claims 1 to 3, wherein switching rated capacity of the first switching element (20) is greater than switching rated capacity of the second switching element (30).

5. The relay device (1) according to any one of claims 1 to 4,
wherein the first switching element (20) is a semiconductor element.
